Europäisches Patentamt

European Patent Office

Office européen des brevets

(11) Publication number: **0 329 427**
A2

## (12) EUROPEAN PATENT APPLICATION

(21) Application number: **89301465.4**

(22) Date of filing: **15.02.89**

(51) Int. Cl.⁴: **H 01 L 31/02**
G 02 F 1/135

(30) Priority: **17.02.88 GB 8803702**

(43) Date of publication of application:
**23.08.89 Bulletin 89/34**

(84) Designated Contracting States: **CH DE FR IT LI**

(71) Applicant: **THE GENERAL ELECTRIC COMPANY, p.l.c.**
**1 Stanhope Gate**
**London W1A 1EH (GB)**

(72) Inventor: **Powles, Clare Mary Jane**
**82 Heath Drive**
**Chelmsford Essex (GB)**

(74) Representative: **Loven, Keith James et al**
**GEC Patent Dept.(Chelmsford Office) GEC-Marconi**
**Research Centre West Hanningfield Road**
**Great Baddow Essex CM2 8HN (GB)**

(54) Thin light blocking layers.

(57) An optical device, in particular a spatial light modulator, comprises a light blocking layer (5) comprising a dye which may be one or several of either food, basic, acid or solvent dyes selected for their specific wavelength absorption characteristics; for their ability to absorb light in only a very thin layer, and for their fade resistance. The dye is preferably contained in a polyimide or other plastics layer, less than 300nm thick.

INPUT  INTERFACE  OUTPUT

1 2 3 4  5 6  FIG. 2.  7 8  9 10 11 12

EP 0 329 427 A2

**Description**

## Thin Light Blocking Layers

This invention concerns thin light blocking layers for use in optical devices such as a spatial light modulator (SLM).

In small scale opto-electronic circuitry and integrated optical equipment it is often necessary to isolate optically one element from another element. This is performed by a permanent light blocking layer, which for many applications must be electrically insulating yet highly optically absorptive. These demands are particularly stringent in the case of an SLM whose imaging performance depends crucially on its layered elements being as thin as possible so as to maintain good spatial resolution.

An SLM having a polyimide light blocking layer is disclosed in our co-pending UK patent application no. GB 8803704. As shown in Figure 1 of the accompanying drawings, an SLM has a layered structure comprising input, interface and output sections. An optical image is converted at the input section to an internal electrical image by photoconduction, and this electrical image is transmitted across the interface to the output section by means of an applied alternating current. The interface section is electrically insulating, and acts as a capacitance, allowing the image to be transferred in the form of an electric field pattern. The output section converts the electrical image back to an optical image using read light. The interface comprises a dielectric mirror which separates optically the input (or write) and output (or read) sections. The light used to write the image onto the input section is typically of a different wavelength and/or degree of coherence from that of the read light.

The quality of the image depends critically on the degree of spatial coherence maintained by the electronic charge carriers as they create a field across the interface, which in turn depends on the conductivity and thickness of the layers constituting the input, interface and output sections.

Conventional light blocking layers in spatial light modulators have been cermets (ceramic, metallic compounds), whose substantial electrical conduction in the plane of the light blocking layer has led to a poor spatial resolution due to the thickness of the layer: fairly thick layers are necessary in order to obtain the required degree of opacity to visible light.

The purpose of the present invention is to provide a light blocking layer which may be made sufficiently thin to preserve spatial coherence yet sufficiently opaque for use, for example, in an SLM.

According to one aspect, the invention provides a spatial light modulator having a light blocking layer comprising a dye between its photoconductive input layer and its imaging output layer.

According to a second aspect, the invention provides an optical device comprising a permanent, uniformly-distributed light blocking layer consisting of an electrically insulating plastics layer less than 300nm thick and containing a dye to render it opaque to visible light.

The use of a dye, is particularly beneficial because dyes are available which are extremely fade resistant, giving a long useful life to the optical device. Dyes are also useful because they are particularly strongly absorbant of light, and are wavelength-specific allowing an appropriate dye or mixture of dyes to be selected for any given use of the device. The mixture of dyes can be taylored to suit their specific absorption bands and relative fade rates.

One way in which the invention may be used will now be described by way of example only, with reference to the accompanying schematic drawings, of which:

Figure 1, referred to above, is a perspective view of an SLM illustrating its imaging function; and

Figure 2 is an exploded perspective view, not to scale, of an SLM embodying the invention.

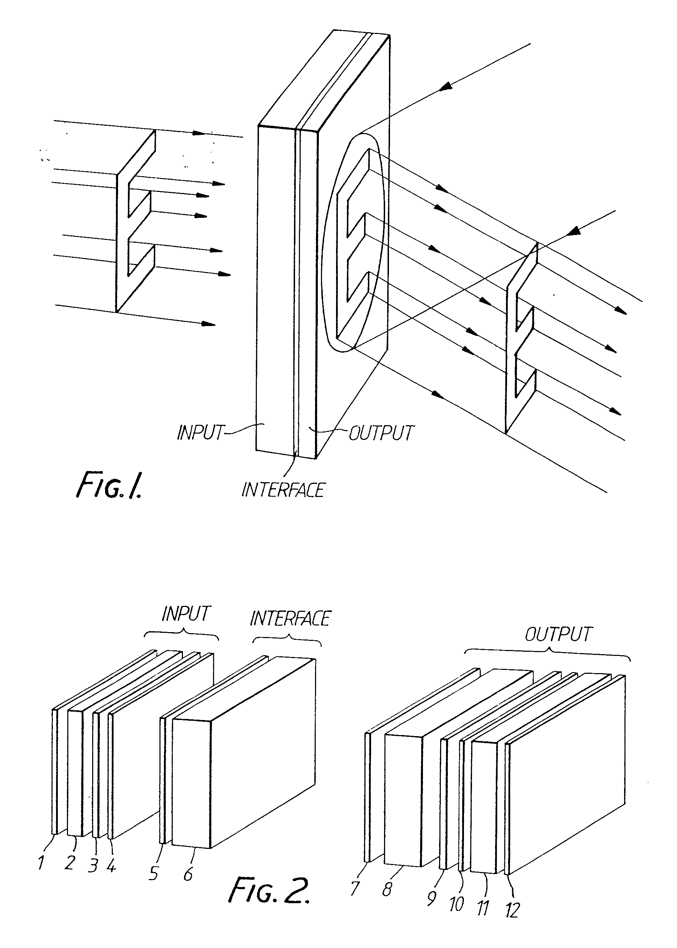

The construction and function of an SLM is well known, and will not be explained in detail. In the example illustrated in Figure 2, an input section, for generating an electrical image in response to an optical image conveyed by write light transmitted through the input section, comprises an anti reflection coating 1, the thickness of which is selected specifically for a particular wavelength of light which is desired to be transmitted, in this example a thickness of about one micron; a glass faceplate 2 of from 1 to 3 millimetres; an indium-tin oxide layer 3 of about 20 nm to 200nm in thickness; and an amorphous-silicon layer 4 of between about 0.5 and 4 microns or thicker.

An interface section, for conveying the electrical image from the input to the output section while reflecting, and/or absorbing the write light transmitted through the input section and read light transmitted through an output section to which it is adjacent, comprises a very thin, permanent, light-blocking interface layer 5 of polyimide of less than 300nm, preferably about 200 nm or even thinner, and a 12 layer dielectric mirror 6, about 1 micron thick, consisting of alternating layers of magnesium fluoride and zinc sulphide. (One alternative to this dielectric mirror would be alternating layers of titanium dioxide and silicon dioxide, but this results in a thicker mirror, giving a poorer performance).

The output section, responsive to the write light to produce an output image corresponding to the electrical image, comprises a twisted nematic cell comprising a layer 8 of liquid crystal in its nematic phase, from 2.0 to 2.5 microns thick, bounded by a pair 7,9 of similar plastics alignment layers, about 50 nm thick, for aligning the liquid crystal molecules; an indium-tin oxide layer 10 of about 20 nm, a glass substrate 11 of about 1mm and an anti-reflection coating 12 of about 1 micron in thickness. The SLM is manufactured by bonding the output section to a separately-prepared combination of the input and interface sections. These sections are prepared by the successive deposition of the different layers using conventional processes. The polyimide layer 5 is applied to the complete input section in the form of a drop of liquid consisting of polyimide in a standard solvent. The drop is applied to the centre of the surface of the amorphous-silicon layer 4, and the input section is then spun at high speed to spread the polyimide evenly across the surface. The thin film thus produced is then cured by baking at a temperature of about 180°C for one hour. The cured interface layer 5 of polyimide appears to act as a protective layer for the amorphous-silicon, in that it seems to absorbs any localised energy imparted by molecular collision, particularly at the temperatures of about 100°C at which the dielectric mirror layers are deposited. The same layer also appears to protect the dielectric mirror from damage by the reaction which would otherwise take place when it is deposited.

The adhesion between the amorphous-silicon and the mirror is also improved by the protective layer 5.

The interface layer 5 of polyimide is particularly suitable because it is durable and inert, and sufficiently electrically non-conductive that, in such a thin layer, its effect on the spatial resolution of the electrical image conveyed from the input section to the output section is minimal. Although polyimide has been found to be particularly useful, other condensation polymers could be used, provided of course that they have similar properties and that they are compatible with the amorphous-silicon and with at least one of the dielectric materials of the dielectric mirror 6.

Some of the dimensions of the layers in this example are specific to the intended wavelength range, and of course the invention is equally applicable to devices with different dimensions, although the intervening polymeric (plastics) layer itself need only be very thin irrespective of the wavelengths used.

The polyimide layer 5 is rendered opaque to visible light of any selected band of wavelengths by mixture with one or several dyes. The layer 5 is uniformly-distributed, having smooth, unbroken, planar faces, and has a light transmission coefficient, for the waveband of interest in the SLM, of lower than $10^{-8}$ $m^{-1}$, preferably lower than $5 \times 10^{-9}$ $m^{-1}$. Some dye mixtures allow the layer to be thinner than 100nm yet still to be sufficiently opaque.

The dyes are dissolved sequentially in polyimide liquid to achieve saturation in respect of each dye, while avoiding premature polymerisation of the mixture and degradation of the dye using careful temperature control, and the mixture is then spun onto the input section 1 to 4. This is achieved by dissolving the individual dyes in sequence in the undiluted polyimide at 80°C - 90°C such that each of the different dyes reaches saturation level, the temperature being controlled carefully to avoid precipitation of the dyes and premature polymerisation. Those dyes which have the best light absorption and fade resistance properties are mixed first. This mixture is then diluted in a suitable solvent such as NMP (n-methyl-1-pyrillidene).

The dyes must also of course be soluble in polyimide (in this particular example). It is known that eosins and erythrosins, being acid dyes, are soluble in polyimide. However, we have discovered that basic dyes, food dyes and solvent dyes have an adequate solubility under careful temperature control and, in many cases, better opacity and/or fade resistance than acid dyes.

In one example, the following dyes were mixed in order (with reference to the Aldrich "CATALOGUE HANDBOOK OF FINE CHEMICALS"): Malachite Green, Fast Green FCF, Sudan Black, Brilliant Green and Methyl Green.

Appropriate dyes may, however, be selected from the following list in accordance with their known bandwidths of absorption, wavelength of selective absorption, and fade resistance: Brilliant Green (a basic dye), Sudan III (solvent), Sudan Black (solvent), Eosin (acid), Eosin Bluish (acid), Erythrosin Y (acid), Fast Green (food), Malachite Green (basic), Methyl Green (basic), Anthraquinone (solvent), Xanthine (solvent) and Rhodamine 6G (basic).

In some applications, a particular class or classes of dye could be excluded from the mixture, e.g. acid dyes.

Although the invention has been illustrated with a light blocking layer which comprises a plastics layer containing a mixture of dyes, satisfactory results may be obtained with only a single dye in a plastics layer, or indeed simply with a film of dye coating the adjacent layer of the optical device, for example the input layer 4 of the illustrated SLM. Such a film could be evaporated under vacuum onto the adjacent layer, or could even be in a liquid supporting medium sandwiched between the two adjacent layers of the SLM and sealed around the edges.

In addition to spatial light modulators, the light blocking layer of the invention may also be used in optical devices such as transducers or modulators or any high density opto-electronic devices where optical isolation on a small scale is crucial.

## Claims

1. A spatial light modulator having a light blocking layer comprising a dye between its photoconductive input layer and its imaging output layer.

2. A spatial light modulator as claimed in claim 1, comprising a dielectric mirror layer between the light blocking layer and the imaging output layer.

3. A spatial light modulator as claimed in claim 1 or 2, in which the light blocking layer consists solely of a layer of dye coating the input layer.

4. A spatial light modulator as claimed in claim 1 or 2, in which the light blocking layer comprises a plastics coating layer containing the dye.

5. A spatial light modulator as claimed in claim 4, in which the plastics layer comprises a polyimide.

6. A spatial light modulator as claimed in any of the preceding claims, in which the light blocking layer is electrically insulating.

7. A spatial light modulator as claimed in any of the preceding claims, in which the light blocking layer is substantially planar on both its faces.

8. A spatial light modulator as claimed in any of the preceding claims, in which the light blocking layer is less than 300nm thick.

9. A spatial light modulator according to any of the preceding claims in which the light blocking layer has a visible light transmission coefficient of lower than $10^{-8}$ per metre.

10. A spatial light modulator as claimed in claim 9 in which the light blocking layer is thinner than 200nm.

11. A spatial light modulator as claimed in claim 1 to 10 in which the light blocking layer is thinner than 100nm.

12. A spatial light modulator according to claim 11, in which the light blocking layer has a visible light transmission coefficient of lower than $5 \times 10^{-9}$ per metre.

13. A spatial light modulator according to any preceding claim in which the light blocking layer comprises one or more of the following dyes: Malachite Green, Fast Green FCF, Sudan Black B, Brilliant Green and Methyl Green.

Fig. I.

INPUT

OUTPUT

INTERFACE

INPUT    INTERFACE

OUTPUT

1  2  3  4    5  6    7  8    9  10  11  12

FIG. 2.